**Europäisches Patentamt**

**European Patent Office**

**Office européen des brevets**

(11) Veröffentlichungsnummer : **0 122 588**
**B1**

(12) **EUROPÄISCHE PATENTSCHRIFT**

(45) Veröffentlichungstag der Patentschrift :
08.07.87

(21) Anmeldenummer : 84104004.1

(22) Anmeldetag : 10.04.84

(51) Int. Cl.⁴ : **H 04 N** **5/21**, H 01 L 27/14,
H 04 N 5/33, G 08 B 13/18

(54) Verfahren zur Übergabe von hintergrundsignalbefreiten Nutzsignalen eines IR-Detektors an einen CCD-Kanal.

(30) Priorität : 16.04.83 DE 3313901

(43) Veröffentlichungstag der Anmeldung :
24.10.84 Patentblatt 84/43

(45) Bekanntmachung des Hinweises auf die Patenterteilung : 08.07.87 Patentblatt 87/28

(84) Benannte Vertragsstaaten :
DE FR GB IT

(56) Entgegenhaltungen :
EP-A- 0 019 269
US-A- 3 845 295
US-A- 4 169 273
IEEE TRANSACTIONS ON ELECTRON DEVICES,
Band ED-29, Nr. 1, Januar 1982, Seiten 3-13, New
York, USA; K. CHOW et al.: "Hybrid infrared focalplane arrays"

(73) Patentinhaber : Licentia Patent-Verwaltungs-GmbH
Theodor-Stern-Kai 1
D-6000 Frankfurt/Main 70 (DE)

TELEFUNKEN electronic GmbH
Theresienstrasse 2
D-7100 Heilbronn (DE)

(72) Erfinder : Gebhardt, Paul-Joachim, Dipl.-Phys.
Franz-Wiedemeier-Strasse 33
D-7900 Ulm (DE)
Erfinder : Maier, Horst, Dr.
Baltenstrasse 14
D-7100 Heilbronn (DE)
Erfinder : Nothaft, Peter, Dr.
Neu Ulmer Strasse 16
D-7910 Neu Ulm/Reutti (DE)
Erfinder : Schulz, Max, Prof. Dr. rer. nat.
Ruhsteinweg 13
D-8521 Uttenreuth (DE)

(74) Vertreter : Schulze, Harald Rudolf, Dipl.-Ing. et al
Licentia Patent-Verwaltungs-GmbH Theodor-Stern-
Kai 1
D-6000 Frankfurt/Main 70 (DE)

**0 122 588**

## Beschreibung

Die Erfindung betrifft ein Verfahren und eine Schaltungsanordnung zur Übergabe von hintergrundsignalbefreiten Nutzsignalen eines IR-Detektors (Infraret-Detektors) an einen CCD-Kanal (Charge-Coupled-Device-Kanal).

Neuzeitliche Wärmebild-Geräte besitzen zur Verbesserung der Empfindlichkeit eine Vielzahl von Einzeldetektoren in der Fokusebene der IR-Optik. Die Forderung nach einer hohen geometrischen Bildauflösung bedingt eine dichte, im allgemeinen zweidimensionale Packung der Detektorelemente. Da die IR-Detektoren eine Betriebstemperatur von typisch $40 \text{ K} < T < 100 \text{ K}$ erfordern, sind die ein- oder zweidimensionalen Detektorarrays in ein Dewargehäuse einzubauen.

Bei zweidimensionalen Multielementarrays ist dabei eine individuelle Herausführung der Signalleitungen von jedem Detektorelement zum zugehörigen Vorverstärker äußerst schwierig. Ein relativ einfaches Detektorsignal-Ausleseverfahrenbieten die ladungsgekoppelten Bauelemente, auch CCD-Schieberegister genannt. CCD-Schieberegister wandeln die Vielzahl der räumlich verteilten Detektorsignale um in ein Zeit-Multiplex-Signal. Diese Parallel-Serien-Wandlung durch die CCD-Schieberegister ergibt eine beträchtliche Verringerung der elektrischen Durchführungen in das Dewargehäuse.

Das vom Detektor-Array auszuwertende Objekt weist üblicherweise eine nur geringe Temperaturdifferenz zu seiner Umgebung bzw. zum Hintergrund auf. Daher ist das der Temperaturdifferenz entsprechende Nutzsignal nur ein Bruchteil des Hintergrundsignals, z. B. 1/100 bis 1/1 000. Um den dynamischen Bereich der CCD-Schieberegister zu erhöhen, ist es notwendig, den vom Hintergrundsignal erzeugten Ladungsanteil vor dem Einlesen in das CCD-Schieberegister zu subtrahieren. Vom CCD-Schieberegister wird dann nur noch ein dem Nutzsignal entsprechender Ladungsanteil weitergeleitet.

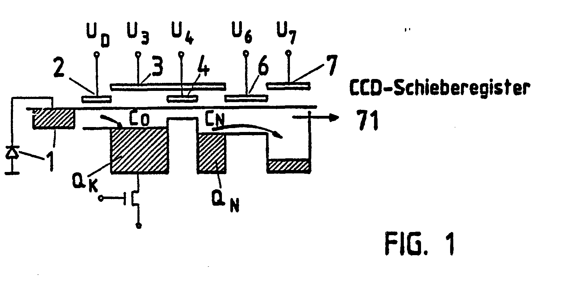

Als Beispiel für eine Hintergrundsignalunterdrückung ist in Fig. 1 eine Detektorsignal-Übergabeschaltung schematisch dargestellt, wie sie aus IEEE Transactions on Electron Devices, Vol. ED-29, No. 1, Jan. 1982, Seiten 3 bis 13 bekannt ist. Diese Schaltung erfordert entweder

eine hohe zu jedem Detektorelement gehörige Speicherkapazität $C_0$, um die während der Integrationszeit $t_0$ angefallene, vom Hintergrund- und Nutzsignal generierte Gesamtladung zu speichern. Erst am Ende der Integrationszeit kann ein dem Hintergrundsignal entsprechender konstanter Ladungsanteil $Q_K$ abgezogen und die verbleibende Ladung $Q_N$ über das CCD-Schieberegister 71 ausgelesen werden oder

eine kurze Integrationszeit $t_1$, um die Speicherung der Gesamtladung auch in kleinerer Specherkapazität $C_0$ vornehmen zu können.

Der erste Fall ist unerwünscht, weil große Speicherflächen (in Fig. 1 die Fläche der Elektrode 3) den Füllfaktor (das Verhältnis der Fläche des Sensor-Elements zur Fläche der Übergabeschaltung) reduzieren. Für den Fall einer photoneninduzierten Generationsrate der Ladungsträger von $2 \cdot 10^{16} \text{ cm}^{-2}\text{s}^{-1}$, einer Integrationszeit von $t_0 = 100 \text{ μs}$ und einer Gatespannung $U_3$ von 10 V ist die Gatefläche der Speicherelektrode 3 bereits gleich der Sensorfläche.

Der zweite Fall ist unerwünscht, weil er hohe Verschiebefrequenzen in der Übergabeschaltung und Taktfrequenzen für das CCD-Schieberegister erfordert. Außerdem wird durch die geringen Ladungsmengen auch das Signal/Rausch-Verhältnis wesentlich verschlechtert. Für den Fall einer Integrationszeit von $t_1 = 10 \text{ μs}$ ergibt sich bei 100 Detektorelemanten bereits eine CCD-Schieberegisterfrequenz von 10 MHz, weil Sensortotzeiten vermieden werden sollen.

CCD-Schieberegister für hohe Frequenzen haben jedoch im allgemeinen einen geringeren dynamischen Bereich und erheblich schlechtere Transfereigenschaften.

Der Erfindung liegt die Aufgabe zugrunde, den Stand der Technik zu verbessern. Insbesondere soll ohne Verschlechterung des Signal/Rausch-Verhältnisses das Verhältnis Detektorfläche/(Fläche der Übergabeschaltung) verbessert werden.

Die Aufgabe wird durch die im Anspruch 1 genannten Verfahrensmerkmale gelöst. Eine vorteilhafte Schaltungsanordnung zur Durchführung des Verfahrens gibt Anspruch 3. Es ist nunmehr möglich, jedem Infrarot-Detektor eine relativ kleinflächige Elektrode für einen Zwischenspeicher zuzuordnen und die einzelnen Nutzsignale während n Zyklen in einem zweiten Zwischenspeicher zunächst aufzusummieren, um sie erst dann an den Eingang des CCD-Kanals des Schieberegisters weiterzuleiten. Das CCD-Schieberegister kann dadurch mit üblicher Taktgeschwindigkeit betrieben werden, so daß keine Verschlechterung seiner Transfereigenschaften auftreten.

Vorteilhafte Weiterbildungen und Ausgestaltungen der Erfindung sind in den Unteransprüchen angegeben. Bei Ausgestaltung der Erfindung nach Anspruch 2 treten keine Rückwirkungen der verbleibenden Ladung des Zwischenspeichers auf das nächstfolgende Detektorsignal ein. Durch die n-malige Aufsummierung des Nutzsignals im Zwischenspeicher C2 ergibt sich eine wesentliche Verbesserung des Füllfaktors bei dieser Detektoranordnung. Da das dem Photonenhintergrundsignal entsprechende Ladungspaket im Zwischenspeicher $C_2$ nicht mehr gespeichert wird, kann die Fläche dieser Speicherelektroden beträchtlich verringert werden. Gleichzeitig wird dadurch die für ein optimales Signal/Rauschverhältnis erforderliche Integrationszeit $t_0$ erreicht, die sich aus n Integrationszyklen mit den Integrationsintervallen $t_1$ zusammensetzt zu : $t_0 = n \cdot t_1$.

Die Erfindung wird nun anhand eines in Zeichnungen dargestellten Ausführungsbeispiels näher

2

erläutert. Es zeigen im einzelnen :

Figur 2   Prinzipschaltbild der Übergabeschaltung

Figur 3   Oberflächenpotential-Verläufe zu sechs aufeinanderfolgenden Zeitpunkten

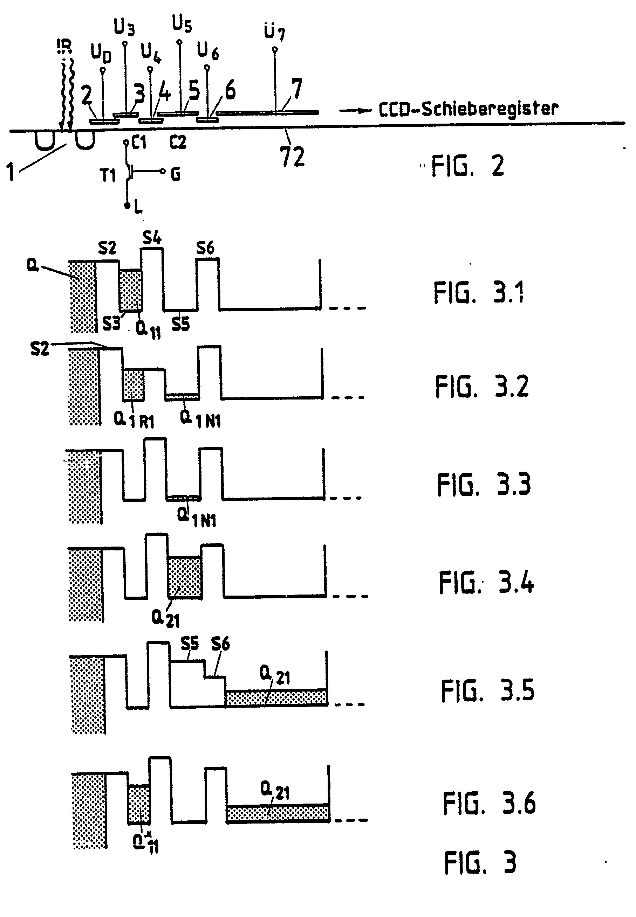

In Fig. 2 ist mit 1 die Detektorfläche des IR-Detektors bezeichnet, die in der als Prinzipschaltbild dargestellten Übergabeanordnung beispielsweise von oben auf die Sensorfläche als Strahlung IR auftreffen möge. Der Detektorbereich des IR-Detektors 1 ist mittels einer sich auf konstantem Potential $U_D$ befindenden ersten Transferelektrode 2 infolge des unter dieser sich ausbildenden Oberflächenpotentials mit einem ersten Zwischenspeicher C1 kontaktiert, der sich unterhalb der diesem zugeordneten Elektrode 3 befindet. Zwischen dem ersten Zwischenspeicher C1 und einem zweiten Zwischenspeicher C2, der sich unter einer Elektrode 5 befindet, ist zur Erzeugung einer elektrischen Schwelle eine Transferelektrode 4 vorgesehen. Ferner ist zwischen dem Speicher C2 und dem Eingang 72 eines CCD-Schieberegisters mit der Eingangselektrode 7 eine weitere Transferelektrode 6 angeordnet, mittels der jeweils nach n Transferzyklen der ersten und zweiten Transferelektrode 2 und 4 die Ladung vom Zwischenspeicher C2 zum Eingang des CCD-Schieberegisters übergebbar ist.

In Fig. 3 ist anhand von sechs Teilzeichnungen mit den Bezeichnungen Fig. 3.1 bis Fig. 3.6 die Wirkungsweise der Schaltungsanordnung anhand der Potential- und Ladungsverteilung am Ende jeweils einer Taktzeit dargestellt. Die Figuren zeigen dabei den Potentialverlauf unter den jeweiligen Elektroden der Anordnung gemäß Fig. 2 im gleichen Maßstab und in dem gleichen Querschnitt des Halbleiterchips.

In einem ersten Zyklus am Ende einer ersten Taktzeit sei der Potentialverlauf S2 bis S7 unter den Elektroden 2 bis 7 durch die Wahl der Spannungen $U_D$ und U3 bis U7 zwischen den Elektroden und dem Substrat des Halbleiterchips entsprechend Fig. 3.1. Von der durch die IR-Strahlung unter der Detektorfläche 1 erzeugten Ladung Q ist über die konstante Potentialschwelle S2 innerhalb einer stets konstanten Integrationszeit $t_1$ eine dem Nutz- und Hintergrundsignal entsprechende Ladungsmenge $Q_{11}$ in den durch die Potentialschwellen S2 bis S4 gebildeten Potentialtopf, der den ersten Zwischenspeicher C1 bildet, geflossen.

In einer zweiten Taktzeit wird nun über die Spannung U4 an der Elektrode 4 das Potential S4 um einen Betrag abgesenkt, der so gewählt ist, daß möglichst lediglich die Ladung $Q_{1N1}$ des Nutzsignalanteils der Ladung $Q_{11}$ in den zweiten Zwischenspeicher $C_2$ unter die Elektrode 5 abfließt (Skimming-Verfahren). Den Potential- und Ladungsverlauf am Ende dieser Taktzeit zeigt Fig. 3.2.

In einer dritten Taktzeit wird die Potentialschwelle S4 wieder auf den ursprünglichen Wert erhöht und über den Feldeffekttransistor T1 (Fig. 2) in an sich bekannter Weise die Ladung $Q_{1R1}$ des Speichers C1 entfernt. Hierzu ist die Drain-Elektrode des Transistors T1 an einer auf Bezugspotential liegenden Sammelleitung L angeschlossen. Die Source-Elektrode des Transistors T1 ist technologisch mit dem Bereich unter der Elektrode 3 identisch. Durch einen Spannungsimpuls an der Gateelektrode G des Transistors T1 läßt sich die Ladung des Speichers C1 ableiten. Die Potential- und Ladungsverteilung am Ende der dritten Taktzeit zeigt Fig. 3.3.

Dieser aus drei Taktzeiten bestehende Zyklus wird nun gemäß der Erfindung n mal wiederholt. Dabei wird die Ladung vorwiegend entsprechend dem Nutzsignal im Speicher C2 unter der Elektrode 5 zur Ladung $Q_{21}$ summiert, so daß gilt

$$Q_{21} = Q_{1N1} + Q_{1N2} + Q_{1N3} + ... + Q_{1Nn} ;$$

wobei n beispielsweise 10 sein kann. Die Potential- und Ladungsverteilung am Ende von n Zyklen zeigt Fig. 3.4.

In einer weiteren Taktzeit werden die Spannungen an den Elektroden 5 und 6 nun so angelegt, daß durch den sich dadurch ergebenden Potentialverlauf, wie ihn die Figuren 3.5 und 3.6 zeigen, die Ladung $Q_{21}$ in den Eingang 72 des CCD-Kanals und damit unter die Eingangselektrode 7 des CCD-Schieberegisters transferiert wird.

Gemäß Fig. 3.6 ist in einer weiteren Taktzeit wieder eine Ladungsmenge $Q^*_{11}$ vom IR-Detektor in den Speicher C1 eingeflossen. Der Vorgang läuft wieder wie beschrieben ab.

Jeweils in der ersten Taktzeit eines Zyklus wird der IR-Detektor belichtet und der Speicher C1 entsprechend der Belichtungsintensität gefüllt. Steht für diesen Prozeß bei einer Infrarot-Anwendung die Integrationszeit $t_1$ bzw. die entsprechende Integrationsfrequenz $f_1 — 1/t_1$ zur Verfügung, so ergibt sich für die Übergabefrequenz $f_T$ der im Zwischenspeicher C2 nach n Integrationszyklen aufsummierten Nutzsignalladungen in den CCD-Auslesekanal $f_T = f_1/n$.

Für die Auslesung der aufsummierten Ladung $Q_{21}$ im CCD-Kanal steht die Zeit $t_o = n \cdot t_1$ aus n Zyklen zur Verfügung. Sind p Detektoren einer Detektorzeile mit dieser vorgeschlagenen Übergabeschaltung an ein CCD zur Parallel-Seriell-Wandlung der Detektorsignale angeschlossen, so folgt somit für die CCD-Auslesefrequenz $f_{CCD} = p \cdot f_T = p \cdot f_1/n$. Dies bedeutet, daß das CCD-Schieberegister mit üblicher Taktfrequenz betrieben werden kann. Das ist besonders vorteilhaft bei zweidimensionalen IR-Detektoranordnungen, bei denen je IR-Detektor eine Übergabeschaltung vorgesehen ist.

Mit n = 10 und einem Verhältnis Nutzsignal/Hintergrundsignal = 1/100 läßt sich dadurch 70-80 % der Elektrodenflächen von Übergabeschaltung und CCD-Schieberegister einsparen, ohne daß eine Verschlechterung des Verhältnisses Signalleistung/Rauschleistung in Kauf genommen werden muß.

## 0 122 588

**Patentansprüche**

1. Verfahren zur Übergabe von hintergrundsignalbefreiten Nutzsignalen eines IR-Detektors an einen CCD-Kanal (Charge-Coupled-Device-Kanal), dadurch gekennzeichnet, daß in einem ersten Zyklus ein eine vorgebbare Schwelle überschreitender Anteil einer in einem ersten Zwischenspeicher (C1) integrierten Ladung des IR-Detektors (1) am Ende der Integrationszeit in einen zweiten Zwischenspeicher (C2) transferiert wird und daß nach n Zyklen (n = ganze Zahl > 1), die im zweiten Zwischenspeicher (C2) aufsummierten Anteile an den Eingang (7) des CCD-Kanals transferiert werden.

2. Verfahren nach Anspruch 1, dadurch gekennzeichnet, daß am Ende eines jeden Zyklus der erste Zwischenspeicher (C1) entladen wird.

3. Schaltungsanordnung zur Durchführung des Verfahrens nach Anspruch 1, dadurch gekennzeichnet, daß der Detektorbereich des IR-Detektors (1) mittels einer sich auf konstantem Potential ($U_D$) befindenden ersten Transfer-Elektrode (2) infolge des unter der ersten Transfer-Elektrode (2) sich ausbildenden Oberflächenpotentials mit einem ersten Zwischenspeicher (C1) kontaktiert ist, daß zwischen dem ersten Zwischenspeicher (C1) und einem zweiten Zwischenspeicher (C2) zur Erzeugung einer elektrischen Schwelle eine zweite Transferelektrode (4) vorgesehen ist und daß zwischen dem zweiten Zwischenspeicher (C2) und dem Eingang (7) des CCD-Kanals eine dritte Transferelektrode (6) vorgesehen ist, mittels der jeweils nach n Transferzyklen der ersten und zweiten Transfer-Elektrode (2 und 4) die Ladung vom zweiten Zwischenspeicher (C2) zum Eingang (7) des CCD-Kanals übergebbar ist.

4. Schaltungsanordnung nach Anspruch 3, dadurch gekennzeichnet, daß der Transfertakt für die erste und zweite Transferelektrode (2 und 4) n-mal so hoch ist wie der der dritten Transferelektrode (6).

5. Schaltungsanordnung nach Anspruch 3 zur Durchführung des Verfahrens nach Anspruch 2, dadurch gekennzeichnet, daß zur Entladung des ersten Zwischenspeichers (C1) ein an seinem Gate steuerbarer MOS-Transistor (T1) vorgesehen ist.

6. Schaltungsanordnung nach einem der Ansprüche 3 bis 4, dadurch gekennzeichnet, daß sie auf einem Halbleiter-Chip mehrfach vorgesehen ist.

**Claims**

1. Method for the transfer of information signals of an infra-red detector, which have been freed of background signal, to a charge-coupled device channel, characterised thereby, that a component, which exceeds a predeterminable threshold, of a charge, which has been integrated in a first intermediate store (C1), of the infrared detector (1) is transferred into a second intermediate store (C2) at the end of the integration time in a first cycle and that the components added up in the second intermediate store (C2) are transferred to the input (7) of the charge-coupled device channel after n cycles (n = whole number > 1).

2. Method according to claim 1, characterised thereby, that the first intermediate store (C1) is discharged at the end of each cycle.

3. Circuit arrangement for the performance of the method according to claim 1, characterised thereby, that the detector region of the infra-red detector (1) is contacted by a first intermediate store (C1) by means of a first transfer electrode (2) disposed at constant potential ($U_D$) in consequence of the surface potential forming beneath the first transfer electrode (2), that a second transfer electrode (4) for the generation of an electrical threshold is provided between the first intermediate store (C1) and a second intermediate store (C2) and that provided between the second intermediate store (C2) and the input (7) of the charge-coupled device channel, there is a third transfer electrode (6), by means of which the charge is transferable from the second intermediate store (C2) to the input (7) of the charge-coupled device channel each time after n transfer cycles of the first and second transfer electrodes (2 and 4).

4. Circuit arrangement according to claim 3, characterised thereby, that the transfer pulse for the first and second transfer electrodes (2 and 4) is n times as great as that of the third transfer electrode (6).

5. Circuit arrangement for the performance of the method according to claim 2, characterised thereby, that an MOS-transistor (T1), controllable at its gate, is provided for the discharge of the first intermediate store (C1).

6. Circuit arrangement according to one of the claims 3 to 4, characterised thereby, that it is provided several times on a semiconductor chip.

**Revendications**

1. Procédé de transfert des signaux utiles d'un détecteur IR, débarrassés du bruit de fond, à un canal CCD (canal à dispositif à couplage de charge), ledit procédé étant caractérisé en ce qu'au cours d'un premier cycle, une composante, supérieure à un seuil prédéterminé, d'une charge du détecteur IR (1) intégrée dans une première mémoire temporaire (C1) est transférée dans une seconde mémoire temporaire (C2) à la fin de la durée d'intégration ; et après n cycles (n = nombre entier > 1), les composantes sommées dans la seconde mémoire temporaire (C2) sont transférées à l'entrée (7) du

4

canal CCD.

2. Procédé selon revendication 1, caractérisé par la décharge de la première mémoire temporaire (C1) à la fin de chaque cycle.

3. Dispositif pour la mise en œuvre du procédé selon revendication 1, caractérisé en ce que le domaine du détecteur IR (1) est connecté à une première mémoire temporaire (C1) par une première électrode de transfert (2) portée à un potentiel constant ($U_D$) et par suite du potentiel superficiel se formant sous ladite électrode ; une deuxième électrode de transfert (4) est prévue entre la première mémoire temporaire (C1) et une seconde mémoire temporaire (C2) pour la production d'un seuil électrique ; et une troisième électrode de transfert (6) est prévue entre la seconde mémoire temporaire (C2) et l'entrée (7) du canal CCD pour le transfert à l'entrée (7) du canal CCD de la charge de la seconde mémoire temporaire (C) après n cycles de transfert de la première et de la deuxième électrode de transfert (2 et 4).

4. Dispositif selon revendication 3, caractérisé en ce que la fréquence de transfert de la première et de la deuxième électrode de transfert (2 et 4) est égale à n fois celle de la troisième électrode de transfert (6).

5. Dispositif selon revendication 3 pour la mise en œuvre du procédé selon revendication 2, caractérisé en ce qu'un transistor MOS (T1) a commande de grille est prévu pour décharger la première mémoire temporaire (C1).

6. Dispositif selon une des revendications 3 et 4, caractérisé en ce qu'il est prévu plusieurs fois sur une puce.

FIG. 1

FIG. 2

FIG. 3.1

FIG. 3.2

FIG. 3.3

FIG. 3.4

FIG. 3.5

FIG. 3.6

FIG. 3